**Europäisches Patentamt**

**European Patent Office**

**Office européen des brevets**

(19)

(11) **EP 1 237 179 A1**

(12) **EUROPEAN PATENT APPLICATION**

(43) Date of publication:
**04.09.2002 Bulletin 2002/36**

(51) Int Cl.$^7$: **H01L 21/00**, H01L 21/321

(21) Application number: **02003192.8**

(22) Date of filing: **18.02.2002**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI** | (72) Inventors:<br>• **Yanagisawa, Michihiko**<br>　**Ayase-city, Kanagawa-pref. 252-1123 (JP)**<br>• **Tanaka, Chikai**<br>　**Ayase-city, Kanagawa-pref. 252-1123 (JP)** |
| (30) Priority: **23.02.2001 JP 2001047674** | (74) Representative: **HOFFMANN - EITLE** |
| (71) Applicant: **Speedfam Co., Ltd.**<br>**Kanagawa 252-1123 (JP)** | **Patent- und Rechtsanwälte**<br>**Arabellastrasse 4**<br>**81925 München (DE)** |

(54) **Local etching method**

(57)     To improve a problem that according to a conventional technology, an accurate planarization is not achieved since an etching rate profile is assumed to be the same regardless of a position of a nozzle relative to a semiconductor wafer, since the etching rate profile is deformed by being influenced by a distance ε, a degree of deformation of the etching rate profile is previously calculated for respective position (distance ε ) of a nozzle and an etching rate calculated thereby is used in calculating nozzle speed at a vicinity of an outer edge.

## FIG. 5

EP 1 237 179 A1

# FIG. 6

# FIG. 7

**Description**

BACKGROUND OF THE INVENTION

1. Field of the Invention

The present invention relates to a wafer planarizing technology for locally etching to planarize projected portions at a surface of a semiconductor wafer, or locally etching relatively thick portions of a semiconductor wafer to thereby make a thickness distribution of the semiconductor wafer uniform by activated species gas, that is, relates to a local etching method or a local etching apparatus.

2. Description of the Related Art

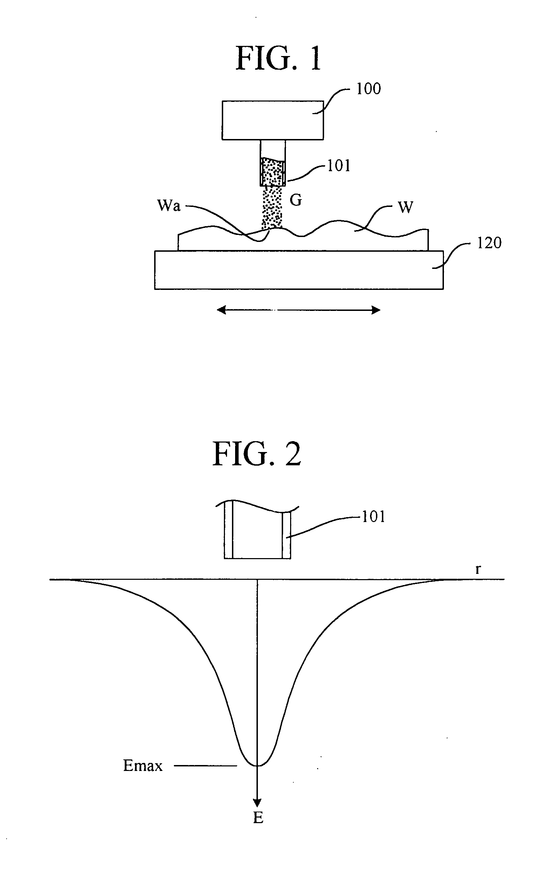

Fig. 1 is an explanatory view for explaining principle of a wafer planarizing method by a local etching method using plasma. Notation 100 designates a plasma generating portion and activated species gas G in plasma generated at the plasma generating portion 100 is injected from a nozzle 101 to a surface of a semiconductor wafer W. The semiconductor wafer W is fixedly mounted onto a stage 120 and the stage 120 is moved at speed controlled in a horizontal direction relative to the nozzle 101.

Initially, a thickness of the semiconductor wafer W differs in accordance with a location. Prior to etching, for respective semiconductor wafer W, a thickness of a respective subdivided area thereof is measured. By the measurement, there is provided data corresponding a position of the respective area and the thickness at the position, that is, position-thickness data. According to the local etching method, an amount of removing a material at the respective region corresponds to a time period of exposing the area to the activated species gas G. Therefore, relative speed for passing the nozzle relative to the semiconductor wafer (hereinafter, referred to as nozzle speed) is determined to speed by which the nozzle is moved at a low speed above a relatively thick portion Wa and at relatively high speed at a relatively thin portion.

Fig. 2 is a graph showing a distribution of an amount (depth) of a semiconductor wafer material per unit time removed by the activated species gas, that is, an etching rate. The curve referred to as an etching rate profile is a curve very similar to a Gaussian distribution. As shown by Fig. 2, the etching rate E is provided with a maximum value Emax on a center line of the nozzle 101 and is reduced as the location becomes remote from the center in a radius r direction.

Since material removing capacity shows a distribution in accordance with a distance from the center of the nozzle in this way, a material removing amount requested for every area cannot be determined only by nozzle speed at every area. The reason is that even when the material is removed by a necessary amount in every area, when etching is carried out for a contiguous area or an area contiguous thereto, the material is removed in accordance with the above-described etching rate profile also for the initial area.

In this way, every area is effected with influence of etching for all of the other areas and therefore, the nozzle speed is calculated such that heights of surfaces of the respective areas become equal to each other as a result of superposing influence of these for all the areas.

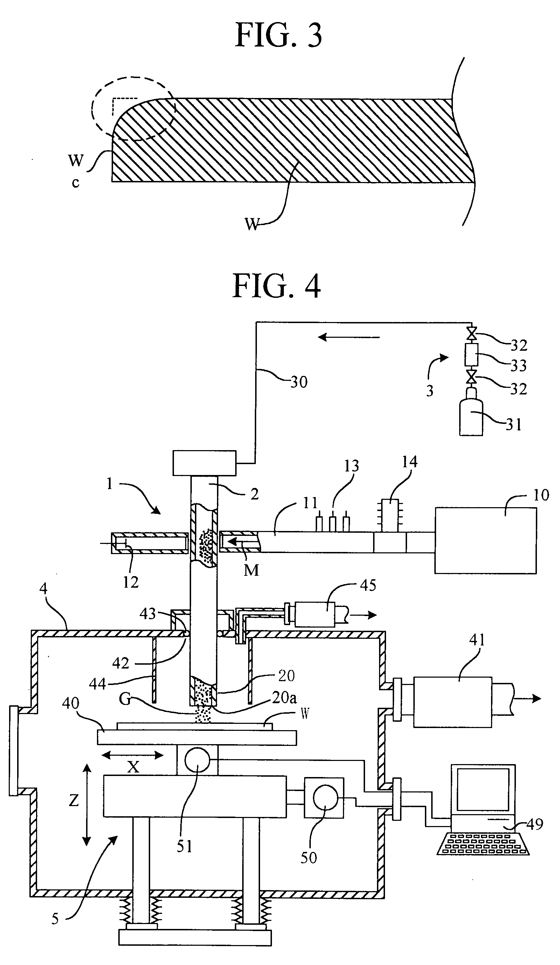

Conventionally, the etching rate profile is dealt with to remain unchanged even when the nozzle is disposed at any position relative to the semiconductor wafer. However, after processing a number of silicon semiconductor wafers, it has bee found that a planarization as expected is not achieved at a vicinity of an outer edge of a semiconductor wafer since there is recognized a tendency that a corner portion slopes down by excessive material removal at a vicinity of an outer edge Wc as is shown in, for example, Fig. 3 by surrounding the corner portion by a dotted line.

There is acquired knowledge that the tendency is caused by assuming that according to the conventional technology, the etching rate profile remains unchanged although the etching rate profile is deformed when the nozzle is disposed at the vicinity of the outer edge of the semiconductor wafer.

It is a problem of the invention to provide local etching method and a local etching apparatus achieving an accurate planarization of a semiconductor wafer including an outer edge thereof by improving the conventional local etching method based on the above-described knowledge.

SUMMARY OF THE INVENTION

The above-described problem can be solved by the following means. That is, according to resolving means of a first aspect of the invention, there is provided a local etching method for a local dry etching apparatus, the local dry etching apparatus comprising a nozzle for injecting an activated species gas to a surface of a semiconductor wafer, a stage for supporting the semiconductor wafer, a drive apparatus for driving either or both of the stage and the nozzle for moving the nozzle relative to the semiconductor wafer in a plane along the surface of the semiconductor wafer, a calculating apparatus for calculating a drive speed of the drive apparatus for relatively moving the nozzle at a lower speed at an area at which a thickness of the semiconductor wafer is relatively thick and relatively moving the nozzle at a higher speed at an area at which the thickness of the semiconductor wafer is relatively thin based on a thickness distribution data at respective areas previously determined on the semiconductor wafer and outputting the drive speed, and a control apparatus for controlling the drive speed by the drive speed outputted from the calculating apparatus, wherein the drive speed is calculated at the calculating apparatus by using etching rates constituting a distribution of removing speeds of removing a material of the semiconductor wafer by the activated species gas and calculated for respective distances between the outer edge of the semiconductor wafer and the nozzle.

According to resolving means of a second aspect of the invention, there is provided a local dry etching apparatus, comprising a nozzle for injecting an activated species gas to a surface of a semiconductor wafer, a stage for supporting the semiconductor wafer, a drive apparatus for driving either or both of the stage and the nozzle for moving the nozzle relative to the semiconductor wafer in a plane along the surface of the semiconductor wafer, a calculating apparatus for calculating a drive speed of the drive apparatus for relatively moving the nozzle at a lower speed at an area at which a thickness of the semiconductor wafer is relatively thick and relatively moving the nozzle at a higher speed at an area at which the thickness of the semiconductor wafer is relatively thin based on a thickness distribution data at respective areas previously determined on the semiconductor wafer and outputting the drive speed, and a control apparatus for controlling the drive speed by the drive speed outputted from the calculating apparatus, wherein the calculating apparatus calculates the drive speed by using an etching rate constituting a distribution of removing speeds for removing a material of the semiconductor wafer by the activated species gas and calculated for respective distances between an outer edge of the semiconductor wafer and the nozzle.

According to resolving means of a third aspect of the invention, there is provided a local etching method for a local dry etching apparatus, the local dry etching apparatus comprising a nozzle for injecting an activated species gas to a surface of a semiconductor wafer, a stage for supporting the semiconductor wafer, a drive apparatus for driving either or both of the stage and the nozzle for moving the nozzle relative to the semiconductor wafer in a plane along the surface of the semiconductor wafer, a calculating apparatus for calculating a drive speed of the drive apparatus for relatively moving the nozzle at a lower speed at an area at which a thickness of the semiconductor wafer is relatively thick and relatively moving the nozzle at a higher speed at an area at which the thickness of the semiconductor wafer is relatively thin based on a thickness distribution data at respective areas previously determined on the semiconductor wafer and outputting the drive speed, and a control apparatus for controlling the drive speed by the drive speed outputted from the calculating apparatus, wherein the drive speed is calculated at the calculating apparatus by using an etching rate constituting a distribution of removing speeds for removing a material of the semiconductor wafer by the activated species gas and constituting a single etching rate regardless of distances between an outer edge of the semiconductor wafer and the nozzle and a drive speed at an outer side of the semiconductor wafer in the calculated drive speed, is further multiplied by a coefficient.

According to resolving means of a fourth aspect of the invention, there is provided a local dry etching apparatus comprising a nozzle for injecting an activated species gas to a surface of a semiconductor wafer, a stage for supporting the semiconductor wafer, a drive apparatus for driving either or both of the stage and the nozzle for moving the nozzle relative to the semiconductor wafer in a plane along the surface of the semiconductor wafer, a calculating apparatus for calculating a drive speed of the drive apparatus for relatively moving the nozzle at a lower speed at an area at which a thickness of the semiconductor wafer is relatively thick and relatively moving the nozzle at a higher speed at an area at which the thickness of the semiconductor wafer is relatively thin based on a thickness distribution data at respective areas previously determined on the semiconductor wafer and outputting the drive speed, and a control apparatus for controlling the drive speed by the drive speed outputted from the calculating apparatus, wherein the calculating apparatus calculates the drive speed by using an etching rate constituting a distribution of removing speeds of removing a material of the semiconductor wafer by the activated species gas and constituting a single etching rate regardless of distances between an outer edge of the semiconductor wafer and the nozzle and a drive speed at an outer side of the semiconductor wafer in the calculated drive speed, is further multiplied by a coefficient.

Other objects and advantages besides those discussed above shall be apparent to those skilled in the art from the description of a preferred embodiment of the invention which follows. In the description, reference is made to accompanying drawings, which form a part thereof, and which illustrate an example of the invention. Such example, however, is not exhaustive of various embodiments of the invention, and therefore reference is made to the claims which follow the description for determining the scope of the invention.

BRIEF DESCRIPTION OF THE DRAWINGS

The accompanying drawings, which are incorporated in and constitute a part of the specification, illustrate embodiments of the invention and together with the description, serve to explain the principles of the invention.

Fig. 1 is an explanatory view for explaining principle of a wafer planarizing method by plasma etching;

Fig. 2 is a graph showing an amount (depth) of a semiconductor wafer material per unit time removed by injected activated species gas, that is, a distribution of an etching rate;

Fig. 3 is an explanatory view showing that a corner portion slopes down by excessive material removal at a vicinity of an outer edge Wc by a conventional local etching method;

Fig. 4 is an explanatory view showing an outline of a local etching apparatus;

Fig. 5 is an explanatory view showing a distance ε from a center of a nozzle to the outer edge Wc of a semiconductor wafer and deformation of an etching rate profile in that case along with Fig. 6 and Fig. 7;

Fig. 6 is an explanatory view showing a distance ε from a center of a nozzle to the outer edge Wc of a semiconductor wafer and deformation of an etching rate profile in that case along with Fig. 5 and Fig. 7;

Fig. 7 is an explanatory view showing a distance ε from a center of a nozzle to the outer edge Wc of a semiconductor wafer and deformation of an etching rate profile in that case along with Fig. 5 and Fig. 6;

Fig. 8 is a plane view showing a semiconductor wafer W, a locus of a nozzle and very small areas;

Fig. 9 is an enlarged view enlarging a portion of Fig. 8; and

Fig. 10(a) shows an etching rate profile and Fig. 10(b) is an explanatory view showing a very small area ΔB subdivided by a pitch p.

DESCRIPTION OF THE PREFERRED EMBODIMENTS

Now, preferred embodiments of the present invention will be described in detail while referring to the accompanying drawings.

Embodiment 1

An explanation will be given of embodiments of the invention in reference to the drawings as follows. Fig. 4 is an explanatory view showing an outline of a local etching apparatus for removing unevenness at a surface of a semiconductor wafer.

The local etching apparatus is provided with a plasma generator 1, a gas supply apparatus 3 and an X-Y drive mechanism 5. The plasma generator 1 is an apparatus for forming a gas in an alumina discharge tube 2 into a plasma to thereby produce activated species gas G including neutral radicals and is provided with a microwave oscillator 10 and a waveguide 11. The microwave oscillator 10 is a magnetron and can oscillate microwave M at predetermined frequency.

The waveguide 11 propagates the microwave M oscillated from the microwave oscillator 10 and the alumina discharge tube 2 is inserted to the waveguide 11. At an inner portion of a left side end of the waveguide 11, there is attached a reflecting plate (short plunger) 12 forming a standing wave by reflecting the microwave M. Further, at middle of the waveguide 11, there are attached a stub tuner 13 for carrying out phase matching of the microwave M and an isolator 14 for bending the reflected microwave M directed to the microwave oscillator 10 in a direction of 90 degrees.

The alumina discharge tube 2 is a cylindrical member formed with a nozzle 20 at its lower end portion and connected with a supply pipe 30 of the gas supply apparatus 3 at its upper end portion. The gas supply apparatus 3 is an apparatus for supplying a gas into the alumina discharge tube 2, having a cylinder 31 of $SF_6$ (sulfur hexafluoride) gas and the cylinder 31 is connected to the supply pipe 30 via valves 32 and a flow rate controller 33. Further, although the sulfur hexafluoride gas can constitute a gas by itself in this way, a mixture gas including the sulfur hexafluoride gas can also be constituted by simultaneously supplying other gas to the supply pipe 30.

When gas is supplied from the gas supply apparatus 3 to the alumina discharge tube 2 and the microwave M is oscillated by the microwave oscillator 10, plasma formation of the gas is carried out at inside of the alumina discharge tube 2. The activated species gas G produced by the plasma formation is injected from the nozzle 20.

The semiconductor wafer W is arranged on a wafer table 40 at inside of a chamber 4 and adsorbed by the wafer table 40 by electrostatic force. The chamber 4 is attached with a vacuum pump 41 and inside of the chamber 4 can be vacuumed (reduce pressure) by the vacuum pump 41. Further, a hole 42 is perforated at a central portion of the ceiling of the chamber 4 and the nozzle 20 of the alumina discharge tube 2 is inserted into the chamber 4 via the hole 42. An O-ring 43 is mounted between the hole 42 and the alumina discharge tube 2 to thereby hold an interval between the hole 42 and the alumina discharge tube 2 in airtight. A duct 44 is provided at a surrounding of the nozzle 20 inserted into the hole 42. Another vacuum pump 45 is connected to the duct 44 and gases produced by reaction in etching are exhausted to outside of the chamber 4 via the duct 44.

The X-Y drive mechanism 5 is arranged at inside of the chamber 4 and supports the wafer table 40 from a lower side thereof. According to the X-Y drive mechanism 5, the wafer table 40 is moved in a left and right direction of Fig. 4 by an X drive motor 50 thereof and the wafer table 40 and the X drive motor 50 are integrally moved in a top and tail direction of the paper face by a Y drive motor 51 thereof. That is, the nozzle 20 can be moved in X-Y directions relative to the semiconductor wafer W by the X-Y drive mechanism 5.

When the valve 32 of the gas supply apparatus 3 is opened, the $SF_6$ gas in the cylinder 31 flows out to the supply pipe 30 and is supplied to the alumina discharge tube 2. The flow rate of the $SF_6$ gas is adjusted by an opening degree of the valve 32.

In parallel with operation of supplying the $SF_6$ gas or the mixture gas, the microwave oscillator 10 is driven. The $SF_6$ gas at inside of the alumina discharge tube 2 is subjected to plasma formation by the microwave M. By the plasma formation of the gas, there is formed the activated species gas G including neutral F (fluorine) radicals. The activated species gas G is guided to the nozzle 20 of the alumina discharge tube 2 and is injected from an opening 20a of the nozzle 20 to the surface of the semiconductor wafer W.

In parallel with injection of the activated species gas, the X-Y drive mechanism 5 is controlled by a control computer 49 and the wafer table 40 is moved by previously calculated speed (mentioned later) along a determined locus.

The injected activated species gas chemically reacts with a material at the surface of the semiconductor wafer. Produced substances produced by the chemical reaction are gaseous, therefore, the produced gases can easily be removed (flowed away) from the side. Thereby, material is removed from the surface of the semiconductor wafer W. A removed amount thereof is substantially proportional to a time period of being exposed to the activated species gas and therefore, the removed amount is controlled by controlling relative speed between the semiconductor wafer W and the nozzle 20. The relative speed is determined based on previously measured data of unevenness of the semiconductor wafer W, that is, position-thickness data.

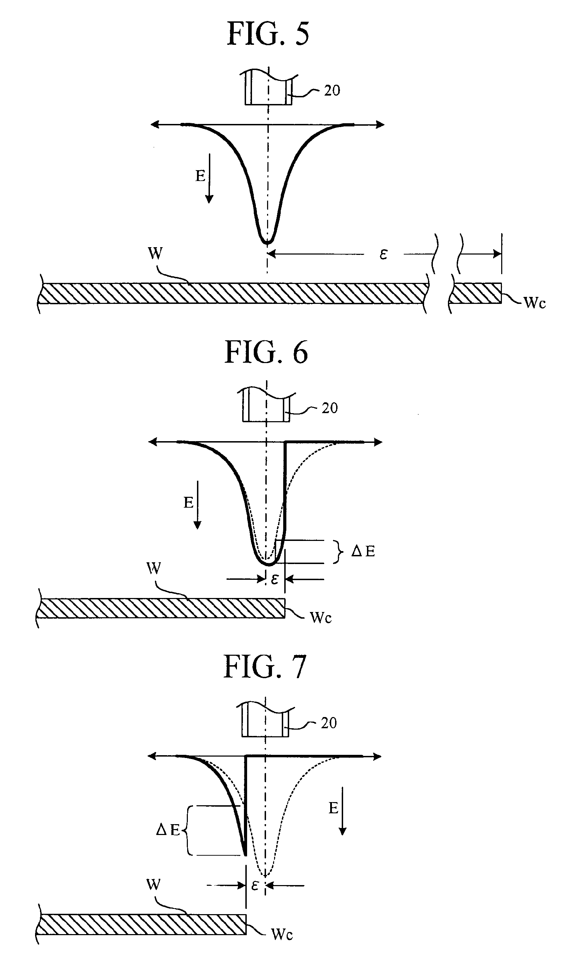

The present invention is based on new knowledge that the conventional way of thinking that the etching rate profile is always symmetrical axially, is partially erroneous, instead thereof, the etching rate profile is dependent on a distance $\varepsilon$ from a center of a nozzle through an outer edge of a semiconductor wafer and is not axially symmetrical. Fig. 5, Fig. 6 and Fig. 7 are explanatory views showing the distance $\varepsilon$ from the center of the nozzle to the outer edge of Wc of a semiconductor wafer and deformation of an etching rate profile in that case.

When the outer edge Wc is sufficiently remote therefrom by the distance $\varepsilon$ in observing a surface of the semiconductor wafer by disposing an observing point on the nozzle 20, the surface looks like a simple plane having substantially infinite spread and having no characteristic. Therefore, activated species gas injected from the nozzle 20 is impacted to the semiconductor wafer, changes a direction of flow and thereafter flows to uniformly spread along the surface of the semiconductor wafer. Therefore, the flow of the activated species gas is symmetrical with respect to a center axis of the nozzle 20 and accordingly, the etching rate E becomes symmetrical with respect to the nozzle axis.

However, at a position approaching the outer edge Wc of the semiconductor wafer, the situation differs from the above-described. The flow of the activated species gas is influenced by the shape of the semiconductor wafer. At the position proximate to the outer edge Wc of the semiconductor wafer, in looking at the surface of the semiconductor wafer by placing the observing point on the central axis of the nozzle 20, the outer edge Wc is brought into the field of vision and the semiconductor wafer can no longer be regarded as the plane having the infinite spread and having no characteristic. Therefore, the flow of the activated species gas is not axially symmetrical and the distribution of the etching rate E is not axially symmetrical. That is, the etching rate profile is deformed.

The deformation of the etching rate profile is caused by still other factor. When the activated species gas is blown to the semiconductor wafer, the activated species in the gas collide with silicon atoms at a constant frequency and cause chemical reaction. The activated species become other compound (gases) by the chemical reaction and lose the activity. When a comparison is made between the activated species gas staying for a long period of time in a space proximate to the surface of the semiconductor wafer and the activated species gas staying in a space remote from the surface of the semiconductor wafer, rates of the activated species included therein differ from each other. Therefore, when attention is paid to an arbitrary block of the activated species gas, the chemical activity as a whole differs for respective block.

Meanwhile, the flow of the gas is provided with a random performance and there is produced an irregular and complicated flow at inside of the chamber of the local etching apparatus. Mixing is caused between new gas immediately after having been injected into the chamber and old gas in which the concentration of the activated species is reduced after elapse of some period of time after injection. Therefore, a portion of gas (or activated species) impacted to the semiconductor wafer is recirculated to a vicinity of the nozzle and joins and mixes with new gas at the vicinity. When the activated species gas flows on the outer side of the outer edge Wc of the semiconductor wafer, the activated species are not consumed since silicon is not present at the outer side. When the gas in which the activated species are not consumed in this way, drifts at inside of the chamber, approaches the nozzle and mixes with new gas immediately after having been injected, the rate of the activated species is increased. Therefore, the activity of the activated species gas is increased and when the gas is blown to surface of the semiconductor wafer, the etching rate is partially increased. As a result, the etching rate profile is deformed.

Fig. 5 shows a case in which the center of the nozzle and the outer edge Wc are remote from each other by the sufficient distance $\varepsilon$, the etching rate profile is not influenced by the outer edge Wc and its symmetry is substantially maintained. Fig. 6 shows an example in which although the center of the nozzle is disposed above the semiconductor wafer, the center of the nozzle is proximate to the outer edge Wc and accordingly, the etching rate profile is deformed by being influenced from the outer edge Wc. In Fig. 6, the etching rate profile of Fig. 5 is indicated by a dotted line for comparison. Further, at an outer side (right side) of the outer edge Wc, the semiconductor wafer is not present and therefore, the etching rate E is null. It is known that on an inner side of the outer edge Wc, the etching rate E is increased by $\Delta E$ at the same position.

Fig. 7 shows an example in which the center of the nozzle is disposed outside of above the semiconductor wafer and proximate to the outer edge Wc. Similar to Fig. 6, the etching rate profile is deformed and the etching rate E is increased by $\Delta E$.

According to the invention, relative speed v of the nozzle is calculated by using the etching rate E which differs in accordance with the distance $\varepsilon$ between the center of the nozzle and the outer edge Wc in this way.

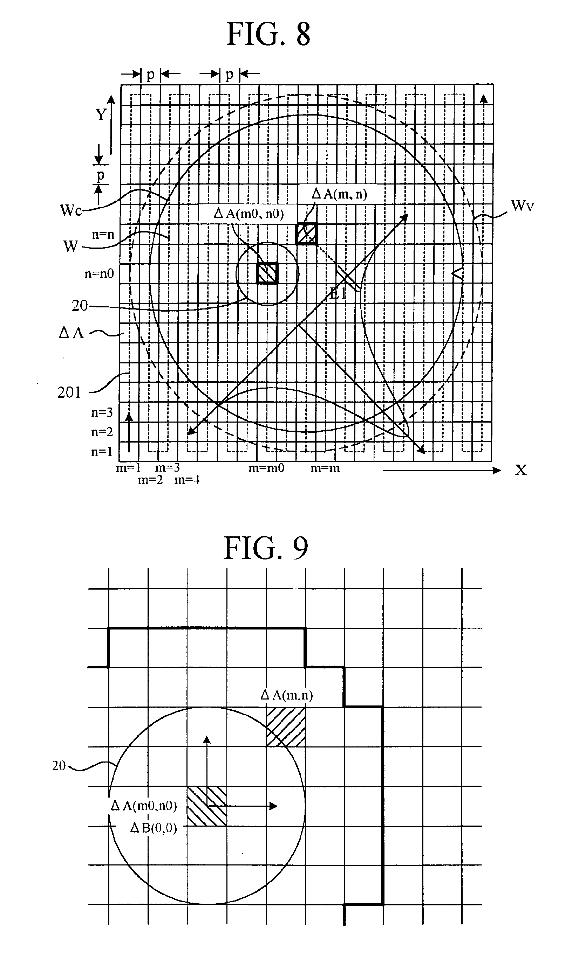

Fig. 8 is a plane view showing the semiconductor wafer W, a nozzle locus 201 and very small areas $\Delta A$. Further, in Fig. 8, there is shown an etching rate profile along a line passing through respective centers of a very small area $\Delta A$ (m0, n0) and a very small area $\Delta A$ (m, n). The etching rate profile shows that by the nozzle the center of which is disposed above the very small area $\Delta A$ (m0, n0), the very small area $\Delta A$ (m, n) on a right upper side, is etched by an etching rate E1. As has already been explained, according to the invention, the etching rate E1 is not regarded to be influenced only by relative positions of the center of the nozzle and the very small area $\Delta A$ (m, n) to be etched, to which the attention is paid at this occasion as in the conventional technology. According to the invention, the etching rate E1 is influenced by the distance $\varepsilon$ between the outer edge Wc and the center of the nozzle other than influence of these and is provided with a value which differs for respective relationship of these.

On an outer side of the semiconductor wafer W, there is conceived an imaginary area Wv larger than the semiconductor wafer W by an effective etching radius and there are conceived squares at pitch p to sufficiently cover imaginary area Wv. By attaching numbers m and n to respectives of the squares, different very small areas are represented. For example, a very small area at m-th order from left and n-th order from a lower side, is designated by notation $\Delta A(m, n)$ and nozzle speed of the very small area $\Delta A(m, n)$ is designated by notation v(m, n). Normally, very small areas $\Delta A$ are assumed by the same number in vertical and horizontal directions on semiconductor wafer coordinates and therefore, when the number is designated by notation k, notations m and n are provided with values of 1<=m<=k, 1<=n<=k.

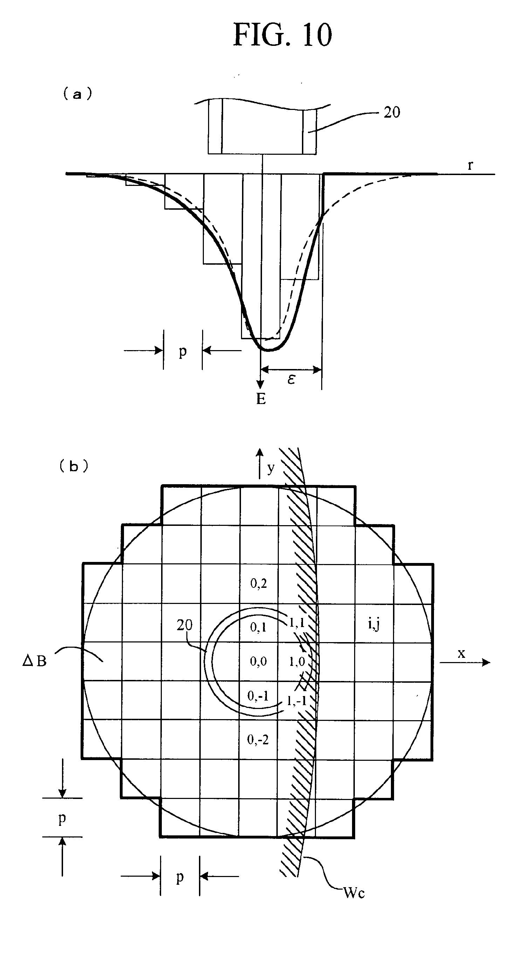

Fig. 9 is an enlarged view enlarging a portion of Fig. 8. Fig. 10(a) is a graph subdividing an abscissa of an etching rate profile by a pitch the same as the pitch p in Fig. 8. Fig. 10(b) shows a very small area $\Delta B$ partitioned by subdivision by the pitch p when the observing point is disposed on the axis line of the nozzle. In correspondence with a respective very small area, similar to the case of Fig. 8, the very small area is designated by notation $\Delta B(i, j)$ by using numerals i and j. For example, a very small area at center is designated by notation $\Delta B(0, 0)$ and a very small area on a right upper side thereof is designated by notation $\Delta B(1, 1)$. Further, the etching rate E in the very small area $\Delta B(i, j)$ is designated as notation E(i, j).

The value of the etching rate E is indicated by a value the best representing a value in the area. A bold line in Fig. 10(b) designates an outermost edge effected by etching. That is, on an outer side of the bold line, even when the nozzle 20 is disposed at any position relative to the outer edge Wc, activated species gas is not provided with etching capacity at outside of the bold line.

The etching rate profile is deformed by being influenced by the distance $\varepsilon$ and therefore, a degree of deforming the etching rate profile is previously calculated for respective position of the nozzle 20, that is, respective distance $\varepsilon$. In calculating the relative speed v, mentioned later, the etching rate E calculated in this way is used at the vicinity of the outer edge Wc. Further, when the nozzle is disposed at a position at which a tangential line of the outer edge Wc is inclined, there is used the etching rate E provided by rotating coordinates of data of the etching rate by an angle of the inclination.

Now, when the center of the nozzle 20 passes through the single very small area $\Delta A(m0, n0)$ by taking time $\Delta t$ (m0, n0), consider an amount (depth) $\Delta D(m, n)$ of etching the very small area $\Delta A(m, n)$ remote therefrom (refer to Fig. 7). Since the center of the nozzle 20 is disposed at the very small area $\Delta B(0, 0)$, the very small area $\Delta B(0, 0)$ and the very small area $\Delta A(m0, n0)$ precisely overlap each other. Positions i and j in viewing the very small area $\Delta A(m, n)$ from above the nozzle are respectively i=m-m0, j=n-n0 and therefore, the etching rate E with respect to the very small area $\Delta A(m, n)$ is represented by notation E(m-m0, n-n0).

Therefore, $\Delta D(m, n)$ is represented as follows.

$$\Delta D(m, n) = E(m-m0, n-n0) * \Delta t(m0, n0) \qquad \text{Equation (1)}$$

When the nozzle 20 passes above respectives of the very small areas $\Delta A$, at the very small area $\Delta A(m, n)$ to which attention is paid currently, there is carried out etching of the amounts $\Delta D$ for the respective positions of the nozzle. Therefore, a total etching amount D (m, n) effected to the very small area ΔA (m, n) to which attention is paid, is calculated by summing up all of ΔD at the respective positions of the nozzle. That is,

$$\Delta D(m, n) = \sum_{m0=0, n0=0}^{m0=k, n0=k} E(m-m0, n-n0) * \Delta t(m0, n0)$$

... Equation (2)

The speed v (which is moving speed in either of vertical and horizontal directions) when the nozzle 20 passes the very small area ΔA, the time Δt required for passing and the pitch p are brought into a relationship of p=v · Δt and therefore, when all of the speed v is known, by using Equation (2), the depth of removing the material can simply be calculated for the respective very small area.

Conversely, when necessary depths of removing the material are previously given and the speeds v are calculated for the respective very small areas, Equation (2) is solved as simultaneous linear equations, times Δt of passing the respective very small areas are calculated and the speeds v of the respective very small areas are calculated therefrom.

The local etching apparatus is normally used for planarizing the surface of the semiconductor wafer. Therefore, with regard to the respective semiconductor wafer W, amounts of unevenness, that is, thicknesses of the respective very small areas are previously measured and given as single position - thickness data for the respective semiconductor wafer. Necessary depths of removing the material are determined from the position - thickness data and therefore, the simultaneous linear equations of Equation (2) are solved. The imaginary area Wv is present on the outer side of the outer edge of the semiconductor wafer at which the material is not present inherently and the speed v is calculated by assuming that the area Wv is provided with a thickness equal to a thickness of the inner area of the outer edge mostly proximate thereto.

Although the calculation is not so easy since as a result, the hypercomplex simultaneous linear equations are solved, application program software on sale can be used. Further, what is important here is to carry out etching such that thicknesses of all of the very small areas are equal. Therefore, the material removing depth D (m, n) of the respective very small area is not absolute but can pertinently be determined relatively in relation with other very small area.

In the above-described very small area, the thickness and the etching rate are dealt with approximately as constant values which remain unchanged. Therefore, the more increased is the number of the very small areas by reducing the pitch p, the finer solution can be provided, however, since time is taken in numerical calculation, a proper size of the pitch p is determined.

Fig. 8 shows the nozzle locus 201 in a zigzag shape. What determines the material removing depth D (m, n) of the respective very small area is time Δt. The speed v at the respective very small area is for making the nozzle present above the very small area by the time Δt. Further, the material removing depth D (m, n) is not depending on the order of etching. Therefore, the direction of moving the nozzle in the respective very small area may be vertical or horizontal and an arbitrary locus can be selected so far as the material can be removed by necessary depths for all of the very small areas. Therefore, the locus shown here is only an example.

Embodiment 2

As has been explained above, according to the local etching method, there are used a plurality of the etching rate profiles, that is, etching rates E (i, j). According to Embodiment 2, instead thereof, as a single profile data for determining coefficients of Equation (2), an etching rate E (i, j) in correspondence with a central portion of the semiconductor wafer can be used without being related to the distance ε as in Embodiment 1. The other is similar to that in the above-described embodiment.

After providing the relative speeds v for the respective very small areas in this way, in the imaginary area Wv, the speed v is approximately calculated by the provided speeds v multiplied by a pertinent coefficient S. The other is calculated by the conventional calculation, the speed V provided thereby can simply be corrected and therefore, the expense is not taken so much. However, a pertinent value of the coefficient S differs by etching conditions and therefore, pertinent trial and error is needed. When the coefficient S is large, it is signified that the time Δt is short, further, when the coefficient S is small, it is signified that the time Δt is long.

When the coefficient S is set as S=1, slope-down as shown by Fig. 3 is produced. At this occasion, the depth is about 0.2 μm. When the coefficient S is set as S=2 under the same conditions, contrary thereto, there is provided a result in which the edge is processed to be higher by about 0.5 μm and when the coefficient S is set as S=3, there is provided a result in which the edge is processed to be higher by about 1.0 μm. As a result, the rate can properly be processed without producing slope-down or an increase in edge height by the coefficient between S=1.1 through S=1.5.

The local etching method according to the invention is based on the knowledge that according to the conventional local etching method, when the nozzle is disposed at the vicinity of the outer edge of the semiconductor wafer, the etching rate profile is deformed and according to the invention, there is achieved an effect of preventing occurrence of excessive material removal caused by the deformation. Further, as a result, there is achieved an effect of providing the accurate planarization over an entire area of the semiconductor including the outer edge of the semiconductor wafer.

Although only preferred embodiments are specifically illustrated and described herein, it will be appreciated that many modifications and variations of the present invention are possible in light of the above teachings and within the purview of the appended claims without departing from scope of the invention.

**Claims**

1. A local etching method for a local dry etching apparatus, said local dry etching apparatus comprising:

    a nozzle for injecting an activated species gas to a surface of a semiconductor wafer;
    a stage for supporting the semiconductor wafer;
    a drive apparatus for driving either or both of said stage and said nozzle for moving said nozzle relative to said semiconductor wafer in a plane along the surface of said semiconductor wafer;
    a calculating apparatus for calculating a drive speed of said drive apparatus for relatively moving the nozzle at a lower speed at an area at which a thickness of said semiconductor wafer is relatively thick and relatively moving the nozzle at a higher speed at an area at which the thickness of the semiconductor wafer is relatively thin based on a thickness distribution data at respective areas previously determined on said semiconductor wafer and outputting the drive speed; and
    a control apparatus for controlling said drive speed by said drive speed outputted from said calculating apparatus;

    wherein said drive speed is calculated at said calculating apparatus by using etching rates constituting a distribution of removing speeds of removing a material of the semiconductor wafer by said activated species gas and calculated for respective distances between the outer edge of the semiconductor wafer and said nozzle.

2. A local dry etching apparatus comprising:

    a nozzle for injecting an activated species gas to a surface of a semiconductor wafer;
    a stage for supporting the semiconductor wafer;
    a drive apparatus for driving either or both of said stage and said nozzle for moving said nozzle relative to said semiconductor wafer in a plane along the surface of said semiconductor wafer;
    a calculating apparatus for calculating a drive speed of said drive apparatus for relatively moving the nozzle at a lower speed at an area at which a thickness of said semiconductor wafer is relatively thick and relatively moving the nozzle at a higher speed at an area at which the thickness of the semiconductor wafer is relatively thin based on a thickness distribution data at respective areas previously determined on said semiconductor wafer and outputting the drive speed; and
    a control apparatus for controlling said drive speed by said drive speed outputted from said calculating apparatus;

    wherein said calculating apparatus calculates said drive speed by using an etching rate constituting a distribution of removing speeds for removing a material of the semiconductor wafer by said activated species gas and calculated for respective distances between an outer edge of the semiconductor wafer and said nozzle.

3. A local etching method for a local dry etching apparatus, said local dry etching apparatus comprising:

    a nozzle for injecting an activated species gas to a surface of a semiconductor wafer;
    a stage for supporting the semiconductor wafer;
    a drive apparatus for driving either or both of said stage and said nozzle for moving said nozzle relative to said semiconductor wafer in a plane along the surface of said semiconductor wafer;
    a calculating apparatus for calculating a drive speed of said drive apparatus for relatively moving the nozzle at a lower speed at an area at which a thickness of said semiconductor wafer is relatively thick and relatively moving the nozzle at a higher speed at an area at which the thickness of the semiconductor wafer is relatively thin based on a thickness distribution data at respective areas previously determined on said semiconductor wafer and outputting the drive speed; and
a control apparatus for controlling said drive speed by said drive speed outputted from said calculating apparatus;

wherein said drive speed is calculated at said calculating apparatus by using an etching rate constituting a distribution of removing speeds for removing a material of the semiconductor wafer by said activated species gas and constituting a single etching rate regardless of distances between an outer edge of the semiconductor wafer and said nozzle and a drive speed at an outer side of the semiconductor wafer in the calculated drive speed, is further multiplied by a coefficient.

4. A local dry etching apparatus comprising:

a nozzle for injecting an activated species gas to a surface of a semiconductor wafer;
a stage for supporting the semiconductor wafer;
a drive apparatus for driving either or both of said stage and said nozzle for moving said nozzle relative to said semiconductor wafer in a plane along the surface of said semiconductor wafer;
a calculating apparatus for calculating a drive speed of said drive apparatus for relatively moving the nozzle at a lower speed at an area at which a thickness of said semiconductor wafer is relatively thick and relatively moving the nozzle at a higher speed at an area at which the thickness of the semiconductor wafer is relatively thin based on a thickness distribution data at respective areas previously determined on said semiconductor wafer and outputting the drive speed; and
a control apparatus for controlling said drive speed by said drive speed outputted from said calculating apparatus;

wherein said calculating apparatus calculates said drive speed by using an etching rate constituting a distribution of removing speeds of removing a material of the semiconductor wafer by said activated species gas and constituting a single etching rate regardless of distances between an outer edge of the semiconductor wafer and said nozzle and a drive speed at an outer side of the semiconductor wafer in the calculated drive speed, is further multiplied by a coefficient.

# FIG. 1

# FIG. 2

# FIG. 3

W
c

W

# FIG. 4

32
33
32
30
3
31
1
2
11
13
14
10
12
M
4
45
43
42
44
20
20a
G
W
40
41
X
Z
51
50
49
5

# FIG. 5

# FIG. 6

# FIG. 7

# FIG. 8

# FIG. 9

# FIG. 10

(a)

(b)

European Patent
Office

**EUROPEAN SEARCH REPORT**

Application Number

EP 02 00 3192

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 514 046 A (HUGHES AIRCRAFT CO) 19 November 1992 (1992-11-19) * column 5, line 23 - column 7, line 24 * | 1-4 | H01L21/00 H01L21/321 |
| X | EP 0 975 016 A (SPEEDFAM CO LTD ;HORIIKE YASUHIRO (JP)) 26 January 2000 (2000-01-26) * abstract * * paragraph '0052! - paragraph '0053! * | 1-4 | |
| X | US 6 159 388 A (IIDA SHINYA ET AL) 12 December 2000 (2000-12-12) * column 1 - column 2; figure 19 * | 1-4 | |
| A | EP 0 546 842 A (HUGHES AIRCRAFT CO) 16 June 1993 (1993-06-16) * abstract; figure 3 * | | |
| A | US 5 953 578 A (LEE WILLIAM WEI-YEN) 14 September 1999 (1999-09-14) * column 2, line 27 - line 58 * | | TECHNICAL FIELDS SEARCHED (Int.Cl.7) H01L |

The present search report has been drawn up for all claims

| Place of search | Date of completion of the search | Examiner |
|---|---|---|
| MUNICH | 7 June 2002 | Pusch, C |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 1 237 179 A1**

**ANNEX TO THE EUROPEAN SEARCH REPORT
ON EUROPEAN PATENT APPLICATION NO.** EP 02 00 3192

This annex lists the patent family members relating to the patent documents cited in the above-mentioned European search report.
The members are as contained in the European Patent Office EDP file on
The European Patent Office is in no way liable for these particulars which are merely given for the purpose of information.

07-06-2002

| Patent document cited in search report | | Publication date | Patent family member(s) | | Publication date |
|---|---|---|---|---|---|
| EP 0514046 | A | 19-11-1992 | US | 5254830 A | 19-10-1993 |
| | | | DE | 69228020 D1 | 11-02-1999 |
| | | | DE | 69228020 T2 | 27-05-1999 |
| | | | EP | 0514046 A1 | 19-11-1992 |
| | | | IL | 101474 A | 27-11-1995 |
| | | | JP | 2565617 B2 | 18-12-1996 |
| | | | JP | 5160074 A | 25-06-1993 |
| | | | KR | 9610336 B1 | 30-07-1996 |
| EP 0975016 | A | 26-01-2000 | JP | 2000036488 A | 02-02-2000 |
| | | | EP | 0975016 A1 | 26-01-2000 |
| | | | US | 6280645 B1 | 28-08-2001 |
| | | | US | 2001007275 A1 | 12-07-2001 |
| US 6159388 | A | 12-12-2000 | JP | 10226892 A | 25-08-1998 |
| EP 0546842 | A | 16-06-1993 | US | 5336355 A | 09-08-1994 |
| | | | DE | 69211508 D1 | 18-07-1996 |
| | | | DE | 69211508 T2 | 24-10-1996 |
| | | | EP | 0546842 A1 | 16-06-1993 |
| | | | IL | 104029 A | 08-12-1995 |
| | | | JP | 2118584 C | 06-12-1996 |
| | | | JP | 5347277 A | 27-12-1993 |
| | | | JP | 8031449 B | 27-03-1996 |
| | | | KR | 9700695 B1 | 18-01-1997 |
| US 5953578 | A | 14-09-1999 | NONE | | |

EPO FORM P0459

For more details about this annex : see Official Journal of the European Patent Office, No. 12/82